(19) **Europäisches Patentamt**

**European Patent Office**

**Office européen des brevets**

(11) **EP 1 065 513 B1**

(12) **EUROPÄISCHE PATENTSCHRIFT**

(45) Veröffentlichungstag und Bekanntmachung des Hinweises auf die Patenterteilung:
**07.12.2005  Patentblatt 2005/49**

(51) Int Cl.$^7$: **G01R 33/421**

(21) Anmeldenummer: **00113755.3**

(22) Anmeldetag: **29.06.2000**

(54) **Aktiv abgeschirmte supraleitende Magnetanordnung mit Feldstörungskompensation**

Active shielded superconductive magnet with compensation of field disturbance

Aimant supraconducteur à écran actif et comprenant une compensation des pertubations du champ

(84) Benannte Vertragsstaaten:
**CH DE FR GB LI**

(30) Priorität: **02.07.1999  DE 19930404**

(43) Veröffentlichungstag der Anmeldung:
**03.01.2001  Patentblatt 2001/01**

(73) Patentinhaber: **Bruker BioSpin AG**
**8117 Fällanden (CH)**

(72) Erfinder:
- **Schauwecker, Robert, Dipl.-Phys.**
**8032 Zürich (CH)**
- **Bovier, Pierre-Alain,Dr.sc.nat.,Dipl.-Phys.**
**8051 Zürich (CH)**
- **Eckert, Daniel M.,Dr.sc.nat.,Dipl.-Phys.**
**8600 Dübendorf (CH)**

(74) Vertreter: **Kohler Schmid Möbus**
**Patentanwälte**
**Ruppmannstrasse 27**
**70565 Stuttgart (DE)**

(56) Entgegenhaltungen:
**US-A- 4 764 837        US-A- 5 650 903**

- **PATENT ABSTRACTS OF JAPAN vol. 1999, no. 09, 30. Juli 1999 (1999-07-30) & JP 11 102807 A (KOBE STEEL LTD), 13. April 1999 (1999-04-13)**
- **PATENT ABSTRACTS OF JAPAN vol. 017, no. 310 (E-1380), 14. Juni 1993 (1993-06-14) & JP 05 029137 A (FUJI ELECTRIC CO LTD), 5. Februar 1993 (1993-02-05)**

**Beschreibung**

Die Erfindung betrifft eine supraleitende Magnetanordnung mit mindestens zwei im Betriebszustand über supraleitende Schalter kurzgeschlossenen Strompfaden, in denen unterschiedliche Ströme fließen können, wobei die Magnetanordnung mindestens einen aktiv abgeschirmten supraleitenden Magneten mit einem radial inneren und einem radial äußeren Spulensystem umfaßt, welche näherungsweise den gleichen Strom tragen und näherungsweise entgegengesetzt gleich große Dipolmomente aufweisen, wobei die Strompfade derart ausgelegt sind, daß eine äußere stufenförmige Magnetfeldstörung $\Delta B_z$ in Richtung der Symmetrieachse der Magnetanordnung in einem Arbeitsvolumen im Zentrum der Magnetanordnung im Langzeitverhalten bis auf einen verbleibenden Restbetrag $\beta_\infty \Delta B_z$ unterdrückt wird, mit $|\beta_\infty| < 0,2$.

Derartige aktiv abgeschirmte supraleitende Magnetanordnungen sind bekannt aus US-A 5,329,266 oder US-A 4,926,289.

Das Einsatzgebiet von supraleitenden Magneten umfaßt verschiedene Anwendungsfelder, insbesondere die Magnetresonanzverfahren, in welchen in der Regel die zeitliche Stabilität des Magnetfeldes wichtig ist. Zu den anspruchsvollsten Anwendungen gehört die hochauflösende KernresonanzSpektroskopie (NMR-Spektroskopie). Zeitliche Feldfluktuationen können sowohl vom supraleitenden Magneten selbst als auch von seiner Umgebung verursacht werden. Während mit der aktuellen Magnet- und Leitertechnologie zeitlich sehr stabile Felder erzeugt werden können, besteht auf dem Gebiet der Unterdrückung externer magnetischer Störungen noch Handlungsbedarf. Im folgenden werden Wege aufgezeigt, wie diesen Störungen entgegengewirkt werden kann. Der Schwerpunkt liegt auf dem Gebiet der Störkompensation bei supraleitenden Solenoidmagneten mit aktiver Streufeldabschirmung.

Die US-A 4,974,113 beschreibt u. a. einen kompensierenden supraleitenden Solenoidmagneten, wobei jedoch keine aktive Abschirmung des Magnetsystems erwähnt ist. Die Idee dabei besteht darin, daß mindestens zwei voneinander unabhängige supraleitende Strompfade mittels zweier koaxial angeordneter supraleitender Solenoidspulen realisiert und so berechnet sind, daß auftretende externe Magnetfeldstörungen im Inneren der Anordnung und unter Berücksichtigung der Erhaltung des magnetischen Gesamtflusses für jeden geschlossenen supraleitenden Strompfad im Langzeitverhalten auf einen Restwert von höchstens 20% der ursprünglichen Störung unterdrückt werden.

Eine Anwendung dieser Idee auf ein aktiv abgeschirmtes Magnetsystem ist in der US-A 5,329,266 beschrieben. Dort ist eine Vielzahl von abschirmenden, strukturierten Kompensationsspulen vorgesehen, welche supraleitend in Serie geschaltet sind und jeweils für sich eine im Verhältnis zu den Hauptspulen geringe Stromtragfähigkeit in der Größenordnung von maximal einem Ampere aufweisen, damit im Falle eines Zusammenbruchs der Supraleitung (=Quench) das von der Magnetanordnung nach außen dringende Streufeld möglichst gering bleibt.

Einen alternativen Weg zeigt die US-A 4,926,289 auf, in der ein aktiv abgeschirmtes, supraleitendes Magentsystem mit einem radial inneren und einem radial äußeren, supraleitend kurzgeschlossenen Spulensystem beschrieben ist, wobei zwischen dem inneren und dem äußeren Spulensystem ein supraleitender Kurzschluß mit begrenzter Stromtragfähigkeit vorgesehen ist, der als Differenzstrombegrenzer wirken soll. Eine Kompensation von externen Störungen wird dadurch ermöglicht, daß sich durch den supraleitenden Strombegrenzer zwischen den beiden Spulensystemen eine Verschiebung der Stromverteilung zwischen dem radial inneren und dem radial äußeren supraleitenden Strompfad ergeben kann. Im Quenchfall soll die geringe Stromtragfähigkeit des Differenzstrombegrenzers sicherstellen, daß das von der Magnetanordnung erzeugte externe Streufeld klein bleibt.

Das Problem einer Kompensation von externen Magnetfeldstörungen bei aktiv abgeschirmten Magnetsystemen wird also durch den oben geschilderten Stand der Technik entweder mittels einer oder mehrerer zusätzlich zu den Feldspulen vorgesehenen Kompensationsspulen oder durch eine Unterteilung des Spulensystems in supraleitend kurzgeschlossene Abschnitte dahingehend gelöst, daß homogene äußere Magnetfeldstörungen im Arbeitsbereich des jeweiligen Magnetsystems im Langzeitverhalten auf weniger als 20% reduziert werden.

Aufgabe der vorliegenden Erfindung ist es demgegenüber, auch das Kurzzeitverhalten eines solchen Magnetsystems bei Auftreten einer externen Störung zu verbessern und neue Wege zur Optimierung des dynamischen Störverhaltens aufzuzeigen, die einen möglichst geringen technischen, insbesondere apparativen Aufwand erfordern.

Erfindungsgemäß wird diese Aufgabe dadurch gelöst, daß Abschnitte der über supraleitende Schalter kurzgeschlossenen Strompfade durch Ohm'sche Widerstände überbrückt sind, und daß diese Abschnitte und die Ohm'schen Widerstände so gewählt sind, daß die Magnetfeldstörung im Arbeitsvolumen bereits unmittelbar nach ihrem Auftreten auf einen Restbetrag $\beta_o \Delta B_z$ reduziert ist, wobei $|\beta_o| < |\beta_\infty|$ und daß sich anschließend der Restbetrag $\beta(t)$ $\Delta B_z$ der Magnetfeldstörung im Arbeitsvolumen monoton mit einer Zeitkonstanten $\tau \geq 2$ sec, vorzugsweise $\tau \geq 5$ sec, insbesondere $\tau \approx 20$ sec, dem Wert $\beta_\infty \Delta B_z$ nähert, wobei

$$\beta(t) = 1 + \frac{b \cdot \Delta I(t)}{\Delta B_z}$$

mit

b: Vektor der Magnetfelder jedes Abschnitts ($A_1,A_2,...,A_n$) im Zentrum der Magnetanordnung für jeweils 1 Ampère Strom,

$\Delta I(t)$: Vektor der durch eine stufenförmige Störung $\Delta B_z$ induzierten Stromänderungen in den Abschnitten ($A_1,A_2,...,A_n$),

$$\beta_\infty = \lim_{t \to \infty} \beta(t) ,$$

$$\beta_0 = \beta(t = 0).$$

Mit einer feineren Unterteilung der Strompfade in viele Abschnitte wird das kurzzeitige Verhalten der Störkompensation gegenüber bekannten Magnetsystemen erheblich verbessert. Ferner ist die Überbrückung von Abschnitten der supraleitenden Strompfade mit Widerständen in den meisten bekannten Magneten bereits integraler Bestandteil als Schutzkonzept gegen thermische Schäden im Quenchfall. Zur Optimierung des Störverhaltens realer Magneten muß allerdings der Einfluß dieser Widerstände unbedingt berücksichtigt werden. Es nützt nämlich nichts, wenn ein Magnet nach langer Zeit eine Störung gut kompensiert, aber kurzzeitig z.B. massiv überkompensiert.

Sehr häufig treten Feldstörungen nur sporadisch auf uns verschwinden dann jeweils nach kurzer Zeit. Bei solchen Störungen ist das Langzeitverhalten der Störkompensation nur von untergeordneter Bedeutung, das Kurzzeitverhalten jedoch ausschlaggebend. Dank ihrem optimierten Kurzzeitverhalten besitzt die erfindungsgemäße Störkompensation gerade in diesem Fall markante Vorteile gegenüber dem Stand der Technik.

Besonders vorteilhaft ist die erfindungsgemäße Störkompensation dann, wenn diese zusammen mit einem NMR-Lock betrieben wird. Der NMR-Lock ist ein extrem genauer Feldstabilisator, der aber leider sehr träge ist und deshalb auf schnelle Feldstörungen nicht reagieren kann. Hier setzt nun die Störkompensation ein, indem diese gerade die kurzzeitigen Feldstörungen zu kompensieren vermag und damit eine ideale Ergänzung zum NMR-Lock darstellt.

Daß die Abschnitte nicht supraleitend kurzgeschlossen werden, wie im Stand der Technik z.T. vorgesehen, sondern mit Ohm'schen Widerständen, hat den Vorteil der besseren technischen Realisierbarkeit. Bei einem Magneten mit beispielsweise 20 zusätzlichen supraleitenden Schaltern statt Widerständen würde z.B. beim Laden, wenn alle Schalter offen sind, viel zu viel Wärme in den Heizern entstehen. Problematisch wäre auch das Quenchverhalten, wenn z.B. nur die Abschirmung quencht mit der Folge einer Streufeldüberhöhung und es könnte die Felddrift des Magneten verstärkt werden. Ferner sind mit Widerständen statt supraleitenden Schaltern große Kostenvorteile zu erwarten.

Die obengenannten Vorteile der Erfindung zahlen sich besonders in empfindlichen Systemen aus. Deshalb ist bei einer bevorzugten Ausführungsform die erfindungsgemäße Magnetanordnung Teil einer Apparatur zur hochauflösenden Magnetresonanz-Spektroskopie, beispielsweise auf dem Gebiet der NMR, ICR oder MRI.

NMR-Apparaturen weisen normalerweise eine Einrichtung zur Stabilisierung des im Arbeitsvolumen erzeugten Magnetfeldes auf. Diese verwendet eine Lock-Spule zur Korrektur sowie ein NMR-Signal zur Detektion der Feldstörung und wird als NMR-Lock bezeichnet. Es sollte allerdings gewährleistet sein, daß vorhandene aktive Vorrichtungen zur Kompensation von Magnetfeldfluktuationen, wie z.B. dieser NMR-Lock, nicht mit dem erfindungsgemäßen Entstörkonzept des Magneten wechselwirken. Deshalb ist bei einer Weiterbildung der obigen Ausführungsform vorgesehen, daß die supraleitenden Strompfade von der Lock-Spule entkoppelt sind. Der Vorteil der induktiven Entkopplung der supraleitenden Strompfade von der Lock-Spule besteht darin, daß die Wirkung des NMR-Locks durch den Magneten nicht behindert wird.

Falls das Feld mit sweep-Spulen moduliert werden soll, was an sich aus dem Stand der Technik bekannt ist, darf diese Modulation vom Magneten nicht wie eine externe Störung kompensiert werden. Bei einer anderen Weiterbildung der Erfindung sind daher die supraleitenden Strompfade von den Sweep-Spulen entkoppelt. Der Vorteil der induktiven Entkopplung der supraleitenden Strompfade von den sweep-Spulen besteht darin, daß der Magnet für das sweep-Feld transparent ist.

Bei einer bevorzugten Ausführungsform der erfindungsgemäßen Magnetanordnung sind die Ohm'schen Widerstände Schutzwiderstände zum Schutz der Magnetanordnung gegen thermische und mechanische Zerstörung, bspw. im Quenchfall bei einem ggf. auch teilweisen Zusammenbruch der Supraleitung in der Magnetanordnung. Der Vorteil dieser Ausführungsform besteht in der doppelten Nutzung der Spulenunterteilung in mit Widerständen über-brückte Abschnitte, die einerseits als Schutz der Anordnung im Quenchfall wirken, andererseits gleichzeitig auch der Optimierung des momentanen kurzzeitigen Störfalls dienen.

Bevorzugt ist auch eine Ausführungsform der Erfindung, bei der die Abschnitte, die Ohm'schen Widerstände und die Widerstände der offenen, im Betriebszustand supraleitenden Schalter so dimensioniert sind, daß bei Anlegen einer Ladespannung an die Magnetanordnung während der Ladephase der supraleitenden Strompfade die Stromdifferenzen zwischen benachbarten Abschnitten der Strompfade möglichst gering sind.

Beim Laden eines Teils der Magnetanordnung fließt auch ein Strom über die Parallelwiderstände und die offenen Schalter, wobei "offen" resistiv statt supraleitend bedeutet. Zusätzlich können auch Querströme aus der Widerstandsreihe über die Abgriffe in die Spule fließen und umgekehrt. Der Vorteil der Anordnung gemäß der obigen Ausführungsform besteht darin, daß die Querströme minimiert werden, wodurch das Quenchrisiko während des Ladens an den Stellen, wo die resistiven Abgriffdrähte auf den Supraleiter gelötet sind, vermindert wird. Weil die Ströme über die Widerstandsreihe und damit auch die Querströme zur Ladespannung proportional sind, kann unter Einhaltung der Bedingung gemäß dieser Ausführungsform mit höheren Spannungen schneller geladen werden.

Bei gewissen Magnetanordnungen muß nicht nur ein zeitlich, sondern auch ein örtlich sehr konstantes Feld erzeugt werden. Bei externen Störungen können Probleme mit der örtlichen Homogenität weniger durch eine Inhomogenität des Störfeldes selbst, sondern viel mehr durch ein allenfalls inhomogenes Kompensationsfeld der Magnetanordnung entstehen. Bevorzugt ist daher eine Ausführungsform der Erfindung, bei der die Abschnitte und/oder die Ohm'schen Widerstände und die supraleitenden Strompfade so dimensioniert sind, daß bei Auftreten einer äußeren Magnetfeldstörung die Homogenität des von der Magnetanordnung im Arbeitsvolumen erzeugten Magnetfelds erhalten bleiben. Der Vorteil dieser Anordnung besteht darin, daß die in den supraleitenden Strompfaden durch eine externe Störung induzierten Stromänderungen insgesamt ein Kompensationsfeld aufbauen, das die Grundhomogenität des Magneten nicht beeinträchtigt.

Im folgenden sollen einige konkrete Realisierungsvarianten der Verdrahtung einer erfindungsgemäßen Magnetanordnung angegeben werden:

Eine vorteilhafte Ausführungsform zeichnet sich dadurch aus, daß das radial innere mit dem radial äußeren Spulensystem des aktiv abgeschirmten Magneten in Serie geschaltet ist, wobei diese Serienschaltung einen ersten im Betriebszustand supraleitend kurzgeschlossenen Strompfad bildet, und daß eine mit den beiden Spulensystemen galvanisch gar nicht oder höchstens einfach aber nicht mehrfach verbundene Kompensationsspule koaxial zu den beiden Spulensystemen angeordnet ist und einen weiteren im Betriebszustand supraleitend kurzgeschlossenen Strompfad bildet. Diese Ausführungsform beinhaltet eine einfache, realistische Lösung mit lediglich zwei supraleitend geschlossenen Strompfaden, von denen nur einer mit Abschnitten und Widerständen der oben beschriebenen Art ausgestattet ist. Es ist also nur ein einziger supraleitender Strompfad zusätzlich zum supraleitenden Pfad des Hauptfeldmagneten selbst vorgesehen.

Eine weitere einfache Lösung, bei der keine zusätzlichen Spulen benötigt werden, besteht darin, daß das radial innere mit dem radial äußeren Spulensystem des aktiv abgeschirmten Magneten in Serie geschaltet ist, wobei diese Serienschaltung einen ersten im Betriebszustand supraleitend kurzgeschlossenen Strompfad bildet, und daß ein Teil des inneren und/oder des äußeren Spulensystems des aktiv abgeschirmten Magneten, über einen weiteren supraleitenden Schalter kurzgeschlossen werden kann und dadurch einen weiteren im Betriebszustand supraleitend kurzgeschlossenen Strompfad bildet.

Eine weitere vorteilhafte Ausführungsform, bei der mindestens ein Teil der im Betriebszustand supraleitend kurzgeschlossenen Strompfade miteinander supraleitend in Serie geschaltet ist, bietet demgegenüber noch mehr Freiheitsgrade zur Optimierung des Störungsverhaltens der Magnetanordnung.

Falls verschiedene supraleitende Strompfade z.B. auf unterschiedlichen Magnetsektionen gewickelt sind, ist es einfacher, sie nur resistiv zu verbinden. Durch die resistive Verbindung wird ein gemeinsames Laden ermöglicht. Daher ist eine Ausführungsform vorteilhaft, bei der mindestens ein Teil der im Betriebszustand supraleitend kurzgeschlossenen Strompfade resistiv miteinander verbunden ist, und daß jeder der Strompfade mindestens einen supraleitenden Schalter aufweist.

Dies ist bei einer weiteren Ausführungsform, bei der mindestens ein Teil der im Betriebszustand supraleitend kurzgeschlossenen Strompfade galvanisch nicht verbunden ist, anders gelöst, wodurch sich wiederum mehr Freiheitsgrade für die Optimierung des Störungsverhaltens der Anordnung ergeben. Auf diese Art wird z.B. auch ein supraleitendes Shimsystem mit einbezogen.

Eine bevorzugte Weiterbildung der oben genannten Ausführungsformen sieht vor, daß zumindest an einigen Stellen, an denen nach dem Laden der supraleitenden Magnetanordnung im Initialzustand des Betriebs kein Strom fließt, in die ansonsten supraleitenden Strompfade Strombegrenzer, vorzugsweise für Maximalströme in der Größenordnung weniger Ampere, und/oder Ohm'sche Widerstände in der Größenordnung $\mu\Omega$ bis $m\Omega$ eingefügt sind. Damit lassen sich eine effektive Unterdrückung von Langzeiteffekten bewirken und Probleme wie etwa die Streufelderhöhung während eines Quenchfalles beseitigen oder wenigstens erheblich reduzieren.

Während des Ladens von Teilen der Magnetanordnung müssen unter Umständen mehrere der supraleitend kurzgeschlossenen Pfade unter Strom gesetzt werden, d.h. ihre Schalter müssen gleichzeitig geheizt werden. In anderen supraleitend kurzgeschlossenen Strompfaden, z.B. Kompensationsspulen, Shims etc., muß dagegen ein allfällig induzierter Strom ständig über dem Schalter abgebaut werden, weshalb auch die Schalter dieser Strompfade geheizt werden müssen. Bevorzugt ist daher eine Weiterbildung der erfindungsgemäßen Magnetanordnung, bei der mindestens ein supraleitender Schalter eine Heizeinrichtung aufweist, die mit der Heizeinrichtung des supraleitenden Schalters mindestens eines weiteren Strompfades elektrisch in Serie geschaltet ist. Der Vorteil dieser Anordnung besteht darin, daß durch die Serienschaltung von Schalterheizern die Anzahl der Heizerstromzuleitungen im Stromstab reduziert werden kann, und daß die Handhabung der Magnetanordnung einfacher und sicherer wird.

Bei einer bevorzugten Weiterbildung ist die Heizeinrichtung mindestens eines supraleitenden Schalters sowohl über die Serienschaltung mit einem anderen Schalterheizer als auch separat heizbar. Dadurch können Vorteile der Serienschaltung der Heizer, wie z.B. der einfachen Handhabung, genutzt werden, aber trotzdem können die supraleitenden Strompfade mit zusätzlich separat heizbarem Schalter individuell geladen werden.

Eine besonders bevorzugte Ausführungsform der erfindungsgemäßen Magnetanordnung zeichnet sich dadurch aus, daß die im Betriebszustand supraleitend kurzgeschlossenen Strompfade induktiv voneinander entkoppelt sind. Beim Laden werden daher keine Ströme gegenseitig induziert, welche sich über die offenen Schalter in viel Wärme verwandeln würden. Außerdem erfolgt keine gegenseitige Beeinflussung von driftenden supraleitenden Strompfaden, die z.B. zum stetigen Aufladen einer Spule führen könnten. Beim Quench eines supraleitenden Strompfades, z.B. des Magneten, wird durch einen anderen, z.B. eine Kompensationsspule, nicht plötzlich ein höheres Streufeld erzeugt. Eine vom Magneten entkoppelte Kompensationsspule kann auch als H0-Shim genutzt werden, falls sie ein genügend homogenes Feld erzeugt.

Bei einer vorteilhaften Weiterbildung dieser Ausführungsform wird zur induktiven Entkopplung eine unterschiedliche Polarität des radial inneren und des radial äußeren Spulensystems des aktiv abgeschirmten Magneten ausgenutzt. Die Nutzung der unterschiedlichen Polaritäten von Streufeldabschirmung und Hauptspule erleichtert das Design von Magnetanordnungen gemäß der oben beschriebenen Ausführungsform.

Wenn z.B. Kompensationsspulen auf unterschiedliche Radien verteilt oder mit notch-Strukturen versehen werden, so gewinnt man zusätzliche Freiheitsgrade, um Forderungen wie Entkopplung vom Magneten, Erhaltung der Feldhomogenität während einer Störung und optimale Störkompensation zu erfüllen. Vorteilhaft ist daher eine Ausführungsform der erfindungsgemäßen Magnetanordnung, bei der einer oder mehrere der supraleitend geschlossenen Strompfade Spulen mit unterschiedlichen Wicklungsradien und/oder unterschiedlichen Stromdichten umfassen, wobei diese Spulen mit dem aktiv abgeschirmten Magneten koaxial sind.

Mit dem erfindungsgemäßen Konzept läßt sich mit einfachen Mitteln auch eine höhere Genauigkeit als beispielsweise die in der oben zitierten US-A 4,974,113 genannte Genauigkeit von besser als 20 % bei der Störungskompensation erreichen. Besonders bevorzugt ist daher eine Ausführungsform der Erfindung, bei der die Abschnitte und Ohm'schen Widerstände so gewählt sind, daß über den gesamten Zeitbereich eine Kompensation der äußeren Magnetfeldstörung im Arbeitsvolumen auf einen Restbetrag von weniger als 10%, vorzugsweise weniger als 5%, besonders bevorzugt weniger als 2% bewirkt wird.

Übrigens können mit den erfindungsgemäßen Maßnahmen neben den homogenen Anteilen von Magnetfeldstörungen auch inhomogene Störungen des Magnetfelds im Arbeitsvolumen der Magnetanordnung unterdrückt oder zumindest signifikant gedämpft werden.

In den Rahmen der vorliegenden Erfindung fällt auch ein Verfahren zur Berechnung und Optimierung einer Magnetanordnung der oben beschriebenen erfindungsgemäßen Art, welches sich dadurch auszeichnet, daß der zeitliche Verlauf der Feldstärke des im Arbeitsvolumen erzeugten Magnetfelds nach einer sprungartig einsetzenden äußeren Magnetfeldstörung errechnet und durch Variation der Auslegung der durch Ohmsche Widerstände überbrückten Abschnitte, der Ohm'schen Widerstände sowie der geometrischen Anordnung der im Betriebszustand supraleitend kurzgeschlossenen Strompfade derart beeinflusst wird, dass die Magnetfeldstörung $\Delta Bz$ im Arbeitsvolumen bereits unmittelbar nach ihrem Auftreten auf einen Restbetrag $\beta_0 \cdot \Delta B_z$ reduziert ist, wobei $|\beta_0| < |\beta_\infty|$, und dass sich anschließend der Restbetrag $\beta(t) \cdot \Delta B_z$ der Magnetfeldstörung im Arbeitsvolumen monoton mit einer Zeitkonstanten $\tau \geq 2$ sec, vorzugsweise $\tau \geq 5$ sec, insbesondere $\tau \cong 20$ sec, dem Wert $\beta_\infty \cdot \Delta B_z$ nähert.

Im Gegensatz zu den bekannten Verfahren zur Bestimmung des Verhaltens einer Magnetanordnung unter dem Einfluß einer externen Störung kann mit dem erfindungsgemäßen Verfahren nicht nur das Langzeitverhalten, sondern das gesamte zeitliche Verhalten einer Magnetanordnung optimiert werden. Dies ist dann wichtig, wenn in der Magnetanordnung nicht nur unendliche Zeitkonstanten auftreten, wenn ausschließlich supraleitend geschlossene Strompfade existieren, sondern auch endliche, wenn auch resistiv überbrückte Abschnitte der supraleitend geschlossenen Strompfade existieren. Insbesondere kann die Störkompensation der Magnetanordnung instantan und kurze Zeit nach der Störung optimiert werden.

Bei einer vorteilhaften Weiterbildung des erfindungsgemäßen Verfahrens wird auch der zeitliche Verlauf der 2. Ableitung der Magnetfeldstärke im Arbeitsvolumen nach der Koordinate der Feldrichtung zur Optimierung herangezogen mit dem Ziel, deren zeitliche Änderung nach einer sprungartig einsetzenden äußeren Magnetfeldstörung derart zu beeinflussen, dass die Magnetfeldstörung $\Delta Bz$ im Arbeitsvolumen bereits unmittelbar nach ihrem Auftreten auf einen Restbetrag $\beta_0 \cdot \Delta B_z$ reduziert ist, wobei $|\beta_0| < |\beta_\infty|$, und dass sich anschließend der Restbetrag $\beta(t) \cdot \Delta B_z$ der Magnetfeldstörung im Arbeitsvolumen monoton mit einer Zeitkonstanten $\tau \geq 2$ sec, vorzugsweise $\tau \geq 5$ sec, insbesondere

$\tau \cong 20$ sec, dem Wert $\beta_\infty \cdot \Delta B_z$ nähert.

Es ergeben sich damit die gleichen Vorteile wie bei dem oben beschriebenen Verfahren, aber angewendet auf $d^2B/dz^2 \, |_{z=0}$ (t) statt auf B(t).

Die Erfindung ist in der Zeichnung dargestellt und wird anhand von Ausführungsbeispielen näher erläutert. Es zeigen:

Fig. 1 . ein Schaltschema einer ersten Ausführungsform der erfindungsgemäßen Magnetanordnung mit supraleitenden Verbindungen der supraleitend geschlossenen Strompfade;

Fig. 2 . eine weitere Ausführungsform mit resistiven Verbindungen der supraleitend geschlossenen Strompfade;

Fig. 3 . eine dritte Ausführungsform ohne galvanische Verbindung der supraleitend geschlossenen Strompfade;

Fig. 4 . ein Schaltschema einer supraleitenden, in Abschnitte unterteilten Magnetspule mit Schutzwiderständen; und

Fig. 5 . einen hypothetischen Schaltkreis zur Erläuterung der Berechnungsmethode.

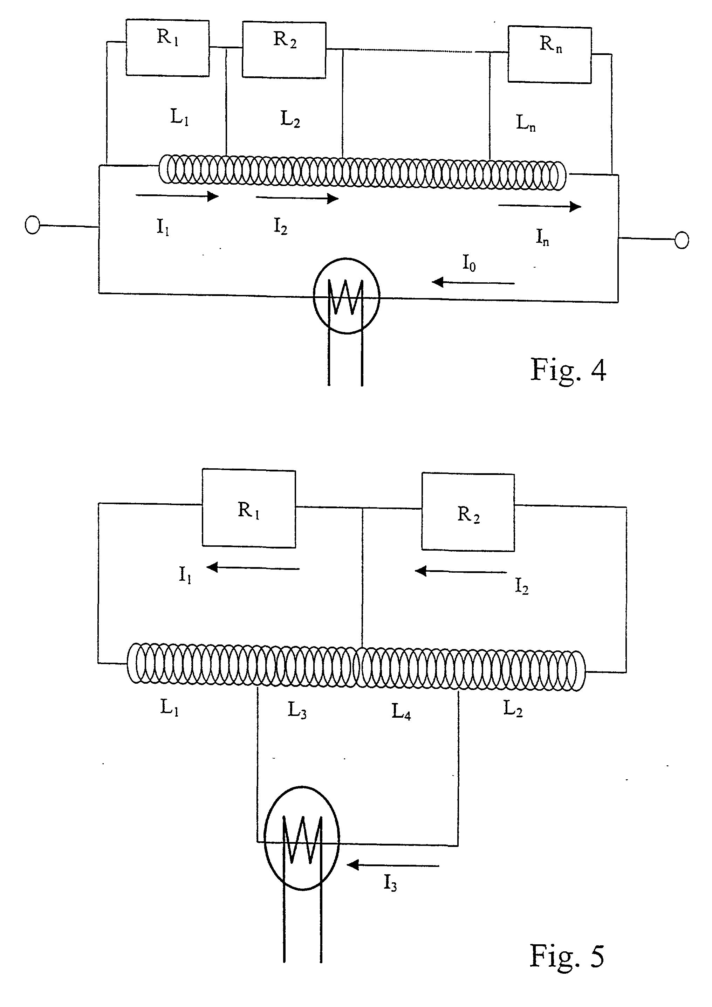

Die Fign. 4 und 5 zeigen hypothetische Schaltkreise für supraleitende Magnetanordnungen, die nicht die vorliegende Erfindung darstellen, sondern lediglich der Erläuterung der nachfolgend vorgeführten Berechnungsmethode dienen.

Eine supraleitende Magnetanordnung besteht meistens aus Spulensystemen. Diese können in Abschnitte unterteilt sein, die mit Widerständen geschützt sind. Eine schematische Darstellung dieser Situation ist in der Figur 4 gegeben.

Die Schutzwiderstände $R_i$ ($i=1, ...,n$) sind den Spulen so angepaßt, daß während des Ladens die Differenzströme zwischen den Abschnitten möglichst klein sind. Dies erreicht man mit der Bedingung

$R_i$ proportional

$$\sum_{j=1}^{n} L_{ij}$$

$i=1,...,n$

wobei $L_{ij}$ die gegenseitigen Induktivitäten bezeichnen.

Mit dem Maschengesetz können die Widerstandströme aus den anderen berechnet werden :

$$I_{Ri} = I_0 - I_i \tag{1}$$

für $i = 1,...,n$

Im Betriebszustand ist die Spannung auf dem gesamten Kreis gleich 0 :

$$0 = \sum_{i=1}^{n} I_{Ri} R_i \overset{(1)}{=} I_0 \sum_{i=1}^{n} R_i - \sum_{i=1}^{n} I_i R_i \tag{2}$$

Wir führen folgende Abkürzungen ein :

$$R_{tot} = \sum_{i=1}^{n} R_i \,, \quad s_i = \frac{R_i}{R_{tot}}$$

Aus (2) folgt jetzt

$$I_0 = \sum_{i=1}^{n} s_i I_i \quad (3)$$

Die einzigen unbekannten Ströme sind nach (1) und nach (3) nur noch $I_1,...,I_n$

Eine äußere Störung induziert über jede Spule $L_i$ eine Spannung $U_i$, auf deren Berechnung wir später noch eingehen werden. Unter Berücksichtigung der gegenseitigen Induktivitäten finden wir für den Schaltkreis Nummer $j$ folgende Spannungsbilanz :

$$U_j - \sum_{i=1}^{n} L_{ij} \frac{dI_i}{dt} - I_{Rj} R_j = 0 \quad (4)$$

Wenn wir (1) und (3) hier einsetzen, bekommen wir

$$U_j - \sum_{i=1}^{n} L_{ij} \frac{dI_i}{dt} - \left( \sum_{i=1}^{n} s_i I_i - I_j \right) R_j = 0 \text{ für } j = 1,...,n$$

Dieses Differentialgleichungssystem lautet in Matrixform :

$$L\frac{dI}{dt} = -RI + U \qquad (5)$$

mit der Induktivitätsmatrix $L$, dem Stromvektor

$$I = \begin{pmatrix} I_1 \\ \vdots \\ I_n \end{pmatrix}$$

dem Spannungsvektor

$$U = \begin{pmatrix} U_1 \\ \vdots \\ U_n \end{pmatrix}$$

und der Widerstandsmatrix

$$R = \begin{pmatrix} R_1 & 0 & \cdots & 0 \\ 0 & R_2 & \cdots & 0 \\ \vdots & \vdots & \ddots & \vdots \\ 0 & 0 & \cdots & R_n \end{pmatrix} - \begin{pmatrix} R_1 s_1 & \cdots & R_1 s_n \\ \vdots & \ddots & \vdots \\ R_n s_1 & \cdots & R_n s_n \end{pmatrix}$$

Diese Betrachtungen können für kompliziertere Spulenanordnungen mit oder ohne Schutzwiderstände verallgemeinert werden. Insbesondere kann man galvanisch nicht verbundene Spulen oder supraleitende Kurzschlüsse miteinbeziehen. Allgemein kann man mit dem Maschengesetz (siehe (1)) zunächst die Anzahl Ströme auf die unabhängigen Stromkreise reduzieren. Nachher kann man in jeder Schlaufe eine Spannungsbilanz aufstellen (siehe (2) und (4)). Am Schluß bekommt man immer eine Gleichung vom Typ (5), wobei $L$ eine Induktivitäts- und $R$ eine Widerstandsmatrix, $I$ ein Strom- und $U$ ein Spannungsvektor sind. Um diesen Sachverhalt zu illustrieren, geben wir diese Größen für den hypothetischen Schaltkreis der Fig. 5 an :

$$L = \begin{pmatrix} L_1 + L_3 + 2L_{13} & L_{12} + L_{14} + L_{34} + L_{23} & L_{13} + L_{14} + L_{34} + L_3 \\ L_{12} + L_{14} + L_{34} + L_{23} & L_2 + L_4 + 2L_{24} & L_{24} + L_{23} + L_{34} + L_4 \\ L_{13} + L_{14} + L_{34} + L_3 & L_{24} + L_{23} + L_{34} + L_4 & L_3 + L_4 + 2L_{24} \end{pmatrix}$$

$$R = \begin{pmatrix} R_1 & 0 & 0 \\ 0 & R_2 & 0 \\ 0 & 0 & 0 \end{pmatrix}; \quad I = \begin{pmatrix} I_1 \\ I_2 \\ I_3 \end{pmatrix}; \quad U = \begin{pmatrix} U_1 + U_3 \\ U_2 + U_4 \\ U_3 + U_4 \end{pmatrix}$$

Wir wollen jetzt die Zeitevolution der Ströme berechnen für $U=0$ und eine anfängliche Stromverteilung $I(t=0)=\Delta I0$ . Das Gleichungssystem (5) läßt sich für diesen Fall exakt lösen, wie wir jetzt zeigen werden. Dafür definieren wir die neue Größe :

$$C = -L^{-1}R$$

Zu lösen ist also

$$\frac{dI}{dt} = CI \tag{6}$$

Wir müssen die Matrix $C$ diagonalisieren. Mit Standard-Methoden kann man eine (meist nicht orthogonale) Transformation $O$ finden, so daß

$$O^{-1}CO = diag(-1/\tau_1,...,-1/\tau_n)$$

eine Diagonalmatrix ist (alle $\tau_i$ sind $\geq 0$). In der Eigenbasis

$$I' = O^{-1}I$$

lautet (6)

$$\frac{dI'}{dt} = diag(-1/\tau_1,...,-1/\tau_n)I'$$

Wir haben also $n$ entkoppelte Differentialgleichungen

$$\frac{dI'_i}{dt} = -\frac{I'_i}{\tau_i}$$

Mit der Anfangsbedingung $I'(t = 0) = O^{-1} \Delta I_0$ lautet die Lösung

$$I'_i(t) = I'_i(0)e^{-t/\tau_i}$$

Die physikalischen Ströme bekommt man mit der Rücktransformation:

$$I(t)=OI'(t) \tag{7}$$

Es ist zu bemerken, daß gewisse Zeitkonstanten $\tau_i$ unendlich sind, gleich viele wie unabhängige supraleitende Strompfade vorhanden sind.

Die Lösung (7) des Differentialgleichungssystems (5) soll nun angewendet werden auf den Fall, daß die anfängliche Stromverteilung $I(t=0)=\Delta I0$ von einer externen Magnetfeldstörung in den Spulenabschnitten induziert wurde. Der Einfachheit halber wollen wir uns auf abrupt eingeschaltete Störungen zur Zeit $t=0$ einschränken, die für spätere Zeiten eingeschaltet bleiben. Da jede Störung eine Überlagerung solcher einfacher Störungen ist, reicht es, wenn wir das Störverhalten unserer Spulenanordnung für solche Störungen optimieren. Ferner wollen wir annehmen, daß unser Magnetsystem vor der Störung im Gleichgewicht ist, daß also keine Ströme über die Widerstände fließen. Welche Ströme in den supraleitenden Teilen fließen, ist für das Störverhalten irrelevant. Wir setzen sie demzufolge gleich null.

Nach dem Induktionsgesetz sind die von einer Störquelle induzierten Spannungen $U_i$ gegeben durch

$$U_i = -\frac{d\Phi_i}{dt}$$

wobei $\Phi_i$ den magnetischen Fluß der Störung durch die Spule $i$ bezeichnet :

$$\Phi_i = \int_i B_z(r,z,\varphi)dA$$

Dabei ist $B_z(r,z,\varphi)$ die $z$-Komponente der Störung im Magnetvolumen.

Der Einfachheit halber lassen wir den Index $i$ weg und schreiben in Vektornotation

$$U=-\frac{d\Phi}{dt}$$

Wie im vorigen Abschnitt erwähnt, wollen wir uns auf abrupt eingeschaltete Störungen beschränken, also

$$B_z(t) = \Delta B_z \cdot \theta(t)$$

wobei $\theta(t)$ die Stufenfunktion bezeichnet. Dann wird

$$U = -\Delta\Phi\delta(t)$$

mit den Komponenten

$$\Delta\Phi_i = \int_i \Delta B_z(r,z,\varphi)dA$$

Nach der Differentialgleichung (5) werden die Ströme zur Zeit $t=0$ unstetig und machen einen Sprung $\Delta I_0$ der Größe

$$\Delta I_0 = -L^{-1}\Delta\Phi \tag{8}$$

Aus (8) sieht man, daß die Größe der Schutzwiderstände für das Kurzzeitverhalten irrelevant ist. Die Einteilung der Spule in geeignete Abschnitte ist aber für das instantane Störverhalten eminent wichtig.

Als Maß für die Störbarkeit eines Magneten definieren wir den Betafaktor β als das Verhältnis zwischen der resultierenden $B_z$-Feld Änderung im magnetischen Zentrum (= Überlagerung der $B_z$-Komponente der Störung und des vom Magneten aufgebauten Kompensationsfeldes) zur $B_z$-Komponente der Störung. Der Betafaktor beschreibt die Fähigkeit eines Magneten, äußere Störungen im magnetischen Zentrum zu kompensieren. Ist beispielsweise β=0, ist die Störung im magnetischen Zentrum unsichtbar. β>0 bedeutet, daß die Induktionsströme die Störung unterkompensieren. β<0 bedeutet hingegen, daß die Induktionsströme so groß sind, daß die Störung im Magnetzentrum überkompensiert wird.

Wenn $\Delta B_z$ die $z$-Komponente des Störfeldes im magnetischen Zentrum bezeichnet (ohne Kompensationsströme des Magneten) und $b$ der Vektor der Magnetfelder jedes Abschnittes ist (Magnetfeld pro Ampere Strom im magnetischen Zentrum), ist der Betafaktor :

$$\beta(t) = 1 + \frac{b \cdot \Delta I(t)}{\Delta B_z},$$

wobei $\Delta I(t)$ die Lösung (7) der Differentialgleichung (5) mit den Anfangswerten $\Delta I_0$ gemäß Gleichung (8) ist.
Im Zähler ist das Skalarprodukt der beiden Vektoren gemeint. Dies ist der sogenannte dynamische Betafaktor.
Wir definieren jetzt die "effektive Fläche" jedes geschlossenen Stromkreises als

$$A_i = \frac{\Delta \Phi_i}{\Delta B_z}$$

Bei einer homogenen Störung ist dies einfach die vom Leiter umschlossene Fläche.

Wird eine Störung abrupt eingeschaltet, reagiert der Magnet sofort mit dem instantanen Betafaktor

$$\beta_0 = 1 + \frac{b \cdot \Delta I_0^{(8)}}{\Delta B_z} = 1 - \frac{b \cdot (L^{-1} \Delta \Phi)}{\Delta B_z} = 1 - b \cdot (L^{-1} A)$$

Die Größe von $\beta_0$ hängt von der jeweiligen Spulenunterteilung ab. Generell stellt man fest, dass bei einer Unterteilung in viele Abschnitte die Störkompensation nahezu ideal wird (β0 ≈ 0). Dies gilt auch für Magneten mit aktiver Streufeldunterdrückung, sofern die Abschirmspule einen oder mehrere separate Abschnitte umfaßt. Die gute instantane Störkompensation bei Magneten mit mehreren Abschnitten ist wenig empfindlich auf Produktionstoleranzen und allfällige Inhomogenität der Störung.

Ist der Magnet vor einer Störung ruhig (d.h., daß keine Ströme in den Schutzwiderständen fließen) und bleibt die Störung zeitlich erhalten, stabilisiert sich der Magnet nach genügend langer Zeit (es fließen also keine Ströme mehr in den Schutzwiderständen). Man spricht dann vom asymptotischen Betafaktor $\beta_\infty$. Diesen kann man zum Beispiel optimieren, indem man mehrere supraleitende Strompfade zuläßt.

Der dynamische Betafaktor bildet den Übergang zwischen instantanem und asymptotischem Betafaktor. Es ist wichtig, daß der Übergang zwischen $\beta_0$ und $\beta_\infty$ monoton ist. Dies ist nicht automatisch gewährleistet.

Das Verhalten einer Magnetanordnung aus $n$ Abschnitten $A_1$ ,..., $A_n$, welche resistiv oder supraleitend überbrückt sind, läßt sich wie folgt zusammenfassend beschreiben. Als Störung wird eine Stufenfunktion des externen Feldes betrachtet. Die Antwort des Systems auf die Störung läßt sich in drei Phasen unterteilen:

1. Der Moment unmittelbar nach der Störung: Das System verhält sich wie $n$ elektrisch unabhängige supraleitende Stromkreise mit $R_i = 0$, die einander nur über die gegenseitige induktive Kopplung beeinflussen. Den β-Faktor des Systems zu diesem Zeitpunkt nennen wir den instantanen β-Faktor β0.

2. Die Dissipationsphase: Unmittelbar nach der Störung fließen unterschiedliche Ströme $I_i$ in den verschiedenen Abschnitten. Im allgemeinen Fall fließen auch Ströme über die Überbrückungswiderstände und werden dort mit den für diese Abschnitte charakteristischen Zeitkonstanten $\tau_i$ dissipiert. Die Zeitkonstanten, mit welchen diese Ströme in den Widerständen nach der Störung relaxieren, entsprechen grob dem Verhältnis von Induktivitäten zu Widerständen. Sie betragen maximal einige zehn Sekunden. In der Basis, welche die Matrix $L^{-1} \cdot R$ diagonal macht, sind die Zeitkonstanten die inversen Eigenwerte der diagonalisierten Matrix. Den β-Faktor des Systems während dieser Phase nennen wir den dynamischen β-Faktor β(t).

3. Das Langzeitverhalten: Nach genügend langer Zeit sind die Ströme über die Widerstände abgebaut und es fließt wieder ein stationärer Strom in allen Abschnitten. Den β-Faktor des Systems in diesem Zeitraum nennen wir den Langzeit-β-Faktor $\beta_\infty$.

Das Störverhalten von Magneten wird durch die β-Faktoren $\beta_0$, $\beta(t)$ und $\beta_\infty$ sowie durch die Zeitkonstanten $\tau_i$ vollständig beschrieben. All diese Parameter können im Design optimiert werden. Da $\beta_\infty$ nicht für alle Störungen auf null gebracht werden kann, ist es wichtig, die Zeitkonstanten möglichst groß zu machen. Für die meisten Anwendungen sind $\beta_0$ und die Zeitkonstanten die ausschlaggebenden Größen für gutes Verhalten bei externen Störungen.

Für die Erhaltung einer guten Homogenität des Magnetfeldes im Arbeitsvolumen ist weniger die Homogenität der Störung ausschlaggebend, als die Homogenität des Kompensationsfeldes des Magneten. Wir betrachten nur den Fall einer axialsymmetrischen Spulenanordnung, weshalb das Kompensationsfeld im Arbeitsvolumen (Annahme: das Arbeitsvolumen befindet sich auf der Symmetrieachse) einzig Feldgradienten in Richtung $z$ der Symmetrieachse aufweist. Ein Maß für die Homogenität sind die Ableitungen (Gradienten):

$$H^k = \left.\frac{d^k B}{dz^k}\right|_{z=0}.$$

Die Magnetanordnung sei nun, wie oben beschrieben, in $n$ Abschnitte unterteilt, welche mit individuellen Stromänderungen auf eine Störung reagieren (Vektor der Stromänderungen $\Delta I(t)$). Sei nun $h^k$ der Vektor der von den Abschnitten pro Ampère erzeugten Gradienten $H^k_j$. Dann lautet die Bedingung für permanente Erhaltung der Homogenität: $h^k \cdot \Delta I(t) = 0$ für alle $k$ und $t$. Instantan muss die Bedingung $h^k \cdot (L^{-1}\Delta\Phi) = 0$ für alle $k$ erfüllt sein, bzw. $h^k \cdot (L^{-1} A) \cdot \Delta B_z = 0$ für eine homogene Störung. Bei einer um eine Mittelebene symmetrischen Anordnung sind nur die $h^k$ mit geraden $k$ nicht null. Aufgrund der üblichen Spulengeometrien ist normalerweise nur die zweite Ordnung $h^2$ relevant.

Bei mehreren supraleitenden Strompfaden ist es wünschenswert, diese induktiv voneinander zu entkoppeln. Vor allem bei aktiv abgeschirmten Magneten kann es sonst zu einer Erhöhung der Streufelder kommen, wenn der Magnet driftet oder wenn sich der Hauptschalter öffnet und sich der Magnet langsam entlädt. Falls die Entkopplung nicht möglich ist, sollten in den zusätzlichen supraleitenden Strompfaden entweder ein kleiner Widerstand oder ein Strombegrenzer eingebaut werden.

Es ist zu empfehlen, daß die Heizer der Schalter der zusätzlichen supraleitenden Strompfade mit dem Hauptschalterheizer des Magneten in Serie geschaltet werden. So ist garantiert, daß beim Laden und Entladen des Magneten mit offenem Hauptschalter die anderen Schalter auch offen sind. Allfällige Restkopplungen zwischen zusätzlichen supraleitenden Strompfaden und Magnet können auf diese Weise nicht zu einem Aufladen dieser Pfade führen.

Für Testzwecke ist es sinnvoll, wenn man die Heizer der Schalter der zusätzlichen supraleitenden Pfade separat betätigen kann. So kann man beispielsweise die Kopplungen der verschiedenen Pfade experimentell bestimmen oder in die verschiedene Pfade verschiedene Ströme einfahren.

Damit die Widerstände, mit denen Abschnitte der supraleitenden Strompfade der Magnetanordnung überbrückt sind, auch eine Schutzfunktion im Quenchfall ausüben können, sollen die Abschnitte und die Widerstände verschiedenen Bedingungen genügen:

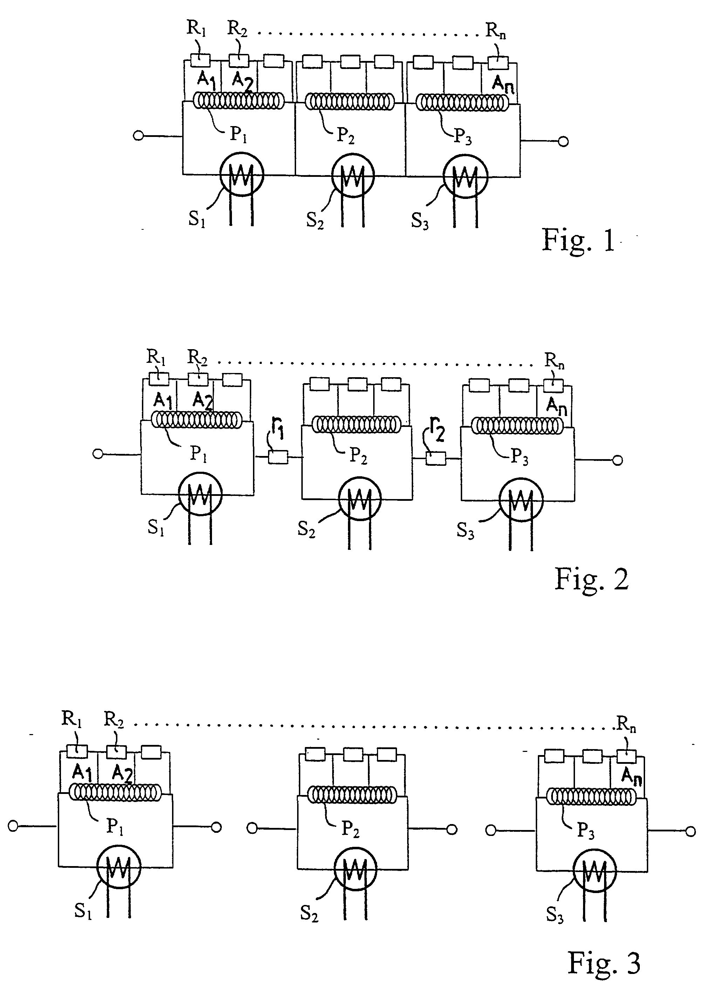

- Die Abschnitte dürfen nicht zu groß sein, damit die Spannung im gequenchten Abschnitt nicht zu groß wird.
- Die Widerstände dürfen nicht zu groß sein, damit der Strom aus dem gequenchten Abschnitt auch über den Widerstand abfließen kann.
- Beim Laden sollen nur kleine Querströme aus der Widerstandsreihe über die Abgriffe in die Spule fließen, weil sonst die Quenchgefahr erhöht würde. Dies erreicht man durch einen Abgleich des induktiven und resistiven Spannungsteilers, wie anhand von Fig. 1 und den zugehörigen Berechnungen erläutert wurde.

Die erfindungsgemäße supraleitende Magnetanordnung kann durch unterschiedliche Schaltungen realisiert werden. Drei konkrete Ausführungsbeispiele sind in den Fign. 1 bis 3 dargestellt.

In den Ausführungsbeispielen sind drei supraleitende Strompfade $P_1$, $P_2$, $P_3$ vorgesehen, die jeweils über einen supraleitenden Schalter $S_1$, $S_2$, $S_3$ kurzgeschlossen sind. Die Strompfade $P_1$, $P_2$, $P_3$ sind durch Ohm'sche Widerstände $R_1$, $R_2$,...,$R_n$ in n Abschnitte $A_1$, $A_2$,...,$A_n$ aufgeteilt, indem der jeweilige Ohm'sche Widerstand $R_i$ parallel zu dem entsprechenden Abschnitt $A_i$ geschaltet ist.

Bei dem Ausführungsbeispiel nach Fig. 1 sind die supraleitend kurzgeschlossenen Strompfade $P_1$, $P_2$ und $P_3$ sowie die zugehörigen supraleitenden Schalter $S_1$, $S_2$ und $S_3$ in Serie geschaltet und über supraleitende Leitungsabschnitte untereinander verbunden.

Alternativ können, wie in Fig. 2 dargestellt, die supraleitenden Strompfade $P_1$, $P_2$, $P_3$ mit den zugehörigen Schaltern $S_1$, $S_2$, $S_3$ aber auch resistiv durch normalleitende Verbindungsstücke $r_1$, $r_2$ in Serie geschaltet sein. Es sei darauf hingewiesen, daß die normalleitenden Verbindungsstücke $r_1$, $r_2$ in Fig. 2 lediglich zur Unterscheidung von Fig. 1 als Ersatzwiderstände dargestellt sind. In der Praxis wird man sie in der Regel nicht durch Widerstände im Sinne von elektrischen Bauteilen, sondern durch einfache, normalleitende Leitungsabschnitte, beispielsweise aus Kupferdraht realisieren.

Im Falle eines Entstörkonzeptes mit einer oder mehreren Kompensationsspulen können die supraleitend kurzgeschlossenen Strompfade $P_1$, $P_2$, $P_3$ auch galvanisch voneinander getrennt angeordnet sein, wie in Fig. 3 dargestellt.

## Patentansprüche

1. Supraleitende Magnetanordnung mit mindestens zwei im Betriebszustand über supraleitende Schalter ($S_1$, $S_2$, $S_3$) kurzgeschlossenen Strompfaden ($P_1$, $P_2$, $P_3$), in denen unterschiedliche Ströme fließen können, wobei die Magnetanordnung mindestens einen aktiv abgeschirmten supraleitenden Magneten mit einem radial inneren und einem radial äußeren Spulensystem umfasst, welche näherungsweise den gleichen Strom tragen und näherungsweise entgegengesetzt gleich große Dipolmomente aufweisen, wobei die Strompfade ($P_1$,$P_2$,$P_3$) derart ausgelegt sind, dass eine äußere, stufenförmige Magnetfeldstörung $\Delta Bz$ in Richtung z der Symmetrieachse der Magnetanordnung in einem Arbeitsvolumen im Zentrum der Magnetanordnung im Langzeitverhalten bis auf einen verbleibenden Restbetrag $\beta_\infty \cdot \Delta B_z$ unterdrückt wird mit $|\beta_\infty| < 0.2$,
**dadurch gekennzeichnet,**
**dass** Abschnitte ($A_1$,$A_2$,...,$A_n$) der über supraleitende Schalter ($S_1$,$S_2$,$S_3$) kurzgeschlossenen Strompfade ($P_1$,$P_2$, $P_3$) durch Ohm'sche Widerstände ($R_1$,$R_2$,...,$R_n$) überbrückt sind, und dass diese Abschnitte ($A_1$,$A_2$,...,$A_n$) und die Ohm'schen Widerstände ($R_1$,$R_2$,...,$R_n$) so gewählt sind, dass die Magnetfeldstörung $\Delta B_z$ im Arbeitsvolumen bereits unmittelbar nach ihrem Auftreten auf einen Restbetrag $\beta_0 \cdot \Delta B_z$ reduziert ist, wobei $|\beta_0|<|\beta_\infty|$, und dass sich anschließend der Restbetrag $\beta(t)\cdot\Delta B_z$ der Magnetfeldstörung im Arbeitsvolumen monoton mit einer Zeitkonstanten $\tau \geq 2$ sec, vorzugsweise $\tau \geq 5$ sec, insbesondere $\tau \cong 20$ sec, dem Wert $\beta_\infty\cdot\Delta B_z$ nähert, wobei

$$\beta(t) = 1+\frac{b\cdot\Delta I(t)}{\Delta B_z}$$

mit

b: Vektor der Magnetfelder jedes Abschnitts ($A_1$,$A_2$,...,$A_n$) im Zentrum der Magnetanordnung für jeweils 1 Ampère Strom,
$\Delta I(t)$: Vektor der durch eine stufenförmige Störung $\Delta B_z$ induzierten Stromänderungen in den Abschnitten ($A_1$, $A_2$,...,$A_n$),

$$\beta_\infty = \lim_{t\to\infty} \beta(t)\,,$$

$$\beta_0 = \beta(t = 0).$$

2. Magnetanordnung nach Anspruch 1, **dadurch gekennzeichnet, dass** die Magnetanordnung Teil einer Apparatur zur hochauflösenden Magnetresonanz-Spektroskopie ist.

3. Magnetanordnung nach Anspruch 2, **dadurch gekennzeichnet, dass** die Magnetresonanz-Apparatur eine Einrichtung zum Feldlock des im Arbeitsvolumen erzeugten Magnetfelds aufweist, wobei die supraleitenden Strompfade ($P_1$, $P_2$, $P_3$) von den Lock-Spulen entkoppelt sind.

4. Magnetanordnung nach Anspruch 2 oder 3, **dadurch gekennzeichnet, dass** die Magnetresonanz-Apparatur Sweep-Spulen aufweist, wobei die supraleitenden Strompfade ($P_1$, $P_2$, $P_3$) von den Sweep-Spulen entkoppelt sind.

5. Magnetanordnung nach einem der vorhergehenden Ansprüche, **dadurch gekennzeichnet, dass** die Ohm'schen

Widerstände ($R_1$, $R_2$,..., $R_n$) im Quenchfall die Funktion von Schutzwiderständen zum Schutz der Magnetanordnung gegen thermische und mechanische Zerstörung übernehmen.

6. Magnetanordnung nach einem der vorhergehenden Ansprüche, **dadurch gekennzeichnet, dass** die Abschnitte ($A_1$,...,$A_n$) und/oder die Ohm'schen Widerstände ($R_1$,...$R_n$) und die supraleitenden Strompfade ($P_1$, $P_2$, $P_3$) so dimensioniert sind, daß bei Auftreten einer äußeren Magnetfeldstörung die Homogenität des von der Magnetanordnung im Arbeitsvolumen erzeugten Magnetfelds erhalten bleibt.

7. Magnetanordnung nach einem der vorhergehenden Ansprüche, **dadurch gekennzeichnet, dass** das radial innere mit dem radial äußeren Spulensystem des aktiv abgeschirmten Magneten in Serie geschaltet ist, wobei diese Serienschaltung einen ersten im Betriebszustand supraleitend kurzgeschlossenen Strompfad ($P_1$) bildet, und dass eine mit den beiden Spulensystemen galvanisch nicht verbundene Kompensationsspule koaxial zu den beiden Spulensystemen angeordnet ist und einen weiteren im Betriebszustand supraleitend kurzgeschlossenen Strompfad ($P_2$, $P_3$) bildet.

8. Magnetanordnung nach einem der vorhergehenden Ansprüche, **dadurch gekennzeichnet, dass** das radial innere mit dem radial äußeren Spulensystem des aktiv abgeschirmten Magneten in Serie geschaltet ist, wobei diese Serienschaltung einen ersten im Betriebszustand supraleitend kurzgeschlossenen Strompfad ($P_1$) bildet, und dass ein Teil des inneren und/oder des äußeren Spulensystems des aktiv abgeschirmten Magneten, über einen weiteren supraleitenden Schalter ($S_2$, $S_3$) kurzgeschlossen werden kann und dadurch einen weiteren im Betriebszustand supraleitend kurzgeschlossenen Strompfad ($P_2$, $P_3$) bildet.

9. Magnetanordnung nach einem der Ansprüche 1 bis 6, **dadurch gekennzeichnet, dass** mindestens ein Teil der im Betriebszustand supraleitend kurzgeschlossenen Strompfade ($P_1$, $P_2$, $P_3$) miteinander supraleitend in Serie geschaltet ist.

10. Magnetanordnung nach einem der Ansprüche 1 bis 6 oder 9, **dadurch gekennzeichnet, dass** mindestens ein Teil der im Betriebszustand supraleitend kurzgeschlossenen Strompfade ($P_1$, $P_2$, $P_3$) resistiv miteinander verbunden ist, und dass jeder der Strompfade ($P_1$, $P_2$, $P_3$) mindestens einen supraleitenden Schalter ($S_1$, $S_2$, $S_3$) aufweist.

11. Magnetanordnung nach einem der Ansprüche 1 bis 6, 19 oder 10, **dadurch gekennzeichnet, dass** mindestens ein Teil der im Betriebszustand supraleitend angeschlossenen Strompfade ($P_1$, $P_2$, $P_3$) galvanisch nicht verbunden ist.

12. Magnetanordnung nach einem der Ansprüche 7 bis 11, **dadurch gekennzeichnet, dass** zumindest an einigen Stellen, an denen nach dem Laden der supraleitenden Magnetanordnung im Initialzustand des Betriebs kein Strom fließt, in die ansonsten supraleitenden Strompfade Strombegrenzer, und/oder Ohm'sche Widerstände in der Größenordnung $\mu\Omega$ bis $m\Omega$ eingefügt sind.

13. Magnetanordnung nach einem der Ansprüche 7 bis 12, **dadurch gekennzeichnet, dass** mindestens ein supraleitender Schalter ($S_1$) eine Heizeinrichtung aufweist, die mit der Heizeinrichtung des supraleitenden Schalters ($S_2$, $S_3$) mindestens eines weiteren Strompfades ($P_2$, $P_3$) elektrisch in Serie geschaltet ist.

14. Magnetanordnung nach Anspruch 13, **dadurch gekennzeichnet, dass** die Heizeinrichtung mindestens eines supraleitenden Schalters ($S_1$) sowohl über die Serienschaltung mit einem anderen Schalterheizer ($S_2$, $S_3$)als auch separat heizbar ist.

15. Magnetanordnung nach einem der vorhergehenden Ansprüche, **dadurch gekennzeichnet, dass** das radial innere und das radial äußere Spulensystem des aktiv abgeschirmten Magneten unterschiedliche Polaritäten aufweisen, so dass die im Betriebszustand supraleitend kurzgeschlossenen Strompfade ($P_1$, $P_2$, $P_3$) induktiv voneinander entkoppelt sind.

16. Magnetanordnung nach einem der vorhergehenden Ansprüche, **dadurch gekennzeichnet, dass** einer oder mehrere der supraleitend geschlossenen Strompfade ($P_1$, $P_2$, $P_3$) Spulen mit unterschiedlichen Wicklungsradien und/oder unterschiedlichen Stromdichten umfassen, wobei diese Spulen mit dem aktiv abgeschirmten Magneten koaxial sind.

17. Magnetanordnung nach einem der vorhergehenden Ansprüche, **dadurch gekennzeichnet, dass** die Abschnitte

($A_1$,...,$A_n$) und Ohm'schen Widerstände ($R_1$,...,$R_n$) so gewählt sind, dass über den gesamten Zeitbereich eine Kompensation der äußeren Magnetfeldstörung im Arbeitsvolumen auf einen Restbetrag von weniger als 10%, vorzugsweise weniger als 5%, besonders bevorzugt weniger als 2% bewirkt wird.

**18.** Verfahren zur Berechnung und Optimierung einer Magnetanordnung nach einem der Ansprüche 1 bis 17, **dadurch gekennzeichnet, dass** der zeitliche Verlauf der Feldstärke des im Arbeitsvolumen erzeugten Magnetfelds nach einer sprungartig einsetzenden äußeren Magnetfeldstörung errechnet und durch Variation der Auslegung der durch Ohmsche Widerstände ($R_1$,...,$R_n$) überbrückten Abschnitte ($A_1$,...,$A_n$), der Ohm'schen Widerstände ($R_1$,..., $R_n$) sowie der geometrischen Anordnung der im Betriebszustand supraleitend kurzgeschlossenen Strompfade ($P_1$, $P_2$, $P_3$) derart beeinflusst wird, dass die Magnetfeldstörung $\Delta$Bz im Arbeitsvolumen bereits unmittelbar nach ihrem Auftreten auf einen Restbetrag $\beta_0 \cdot \Delta$Bz reduziert ist, wobei $|\beta_0| < |\beta_\infty|$, und dass sich anschließend der Restbetrag $\beta(t) \cdot \Delta B_z$ der Magnetfeldstörung im Arbeitsvolumen monoton mit einer Zeitkonstanten $\tau \geq 2$ sec, vorzugsweise $\tau \geq 5$ sec, insbesondere $\tau \cong 20$ sec, dem Wert $\beta_\infty \cdot \Delta$Bz nähert.

**19.** Verfahren nach Anspruch 18, **dadurch gekennzeichnet, dass** auch der zeitliche Verlauf der 2. Ableitung der Magnetfeldstärke im Arbeitsvolumen nach der Koordinate der Feldrichtung zur Optimierung herangezogen wird mit dem Ziel, deren zeitliche Änderung nach einer sprungartig einsetzenden äußeren Magnetfeldstörung derart zu beeinflussen, dass die Magnetfeldstörung $\Delta$Bz im Arbeitsvolumen bereits unmittelbar nach ihrem Auftreten auf einen Restbetrag $\beta_0 \cdot \Delta$Bz reduziert ist, wobei $|\beta_0| < |\beta_\infty|$, und dass sich anschließend der Restbetrag $\beta(t) \cdot \Delta B_z$ der Magnetfeldstörung im Arbeitsvolumen monoton mit einer Zeitkonstanten $\tau \geq 2$ sec, vorzugsweise $\tau \geq 5$ sec, insbesondere $\tau \cong 20$ sec, dem Wert $\beta_\infty \cdot \Delta$Bz nähert.

## Claims

**1.** Superconducting magnet arrangement with at least two current paths ($P_1$,$P_2$,$P_3$) which are short-circuited during operation via superconducting switches ($S_1$,$S_2$,$S_3$) and may carry different currents, wherein the magnet arrangement comprises at least one actively shielded superconducting magnet with a radially inner and a radially outer coil system which carry approximately the same current and have dipole moments of approximately the same magnitude, but opposite in direction, wherein the current paths ($P_1$,$P_2$,$P_3$) are designed to suppress an external magnetic field disturbance $\Delta$Bz, having the shape of a step function, in the direction z of the symmetry axis of the magnet arrangement in a working volume in the center of the magnet arrangement in the long-term behaviour to a remaining residual amount $\beta_\infty \cdot \Delta B_z$ with $|\beta_\infty| < 0.2$, **characterized in that** sections ($A_1$,$A_2$...$A_n$) of the current paths ($P_1$,$P_2$,$P_3$) which are short-circuited via superconducting switches ($S_1$,$S_2$,$S_3$) are bridged via ohmic resistors ($R_1$, $R_2$...$R_n$) and that these sections ($A_1$,$A_2$...$A_n$) and the ohmic resistors ($R_1$,$R_2$...$R_n$) are chosen such that the magnetic field disturbance $\Delta B_z$ in the working volume is reduced already directly after its occurrence to a residual amount $\beta_0 \Delta B_z$, wherein $|\beta_0| < |\beta_\infty|$, and subsequently, the residual amount $\beta(t) \Delta B_z$ of the magnetic field disturbance in the working volume approaches monotonically the value $\beta_\infty \cdot \Delta B_z$ with a time constant of $\tau \geq 2$ sec, preferably $\tau \geq 5$ sec, in particular $\tau \cong 20$ sec, wherein

$$\beta(t) = 1 + \frac{b \cdot \Delta I(t)}{\Delta B_z}$$

with

b: vector of the magnetic fields of each section ($A_1$,$A_2$,...,$A_n$) in the center of the magnet arrangement for a current of 1 ampere in each case,

$\Delta I(t)$: vector of the current changes in the sections ($A_1$,$A_2$,...,$A_n$), induced by a gradual disturbance $\Delta B_z$ having the shape of a step function,

$$\beta_\infty = \lim_{t \to \infty} \beta(t)$$

$$\beta_0 = \beta(t = 0).$$

**2.** Magnet arrangement according to claim 1, **characterized in that** the magnet arrangement is part of an apparatus for high-resolution magnetic resonance spectroscopy.

**3.** Magnet arrangement according to claim 2, **characterized in that** the magnetic resonance apparatus comprises a means for field locking the magnetic field generated in the working volume, wherein the superconducting current paths $(P_1, P_2, P_3)$ are decoupled from the lock coils.

**4.** Magnet arrangement according to claim 2 or 3, **characterized in that** the magnetic resonance apparatus comprises sweep coils, wherein the superconducting current paths $(P_1, P_2, P_3)$ are decoupled from the sweep coils.

**5.** Magnet arrangement according to any one of the preceding claims, **characterized in that** the ohmic resistors $(R_1, R_2, ...R_n)$ take over the function of protective resistors in case of a quench to protect the magnet arrangement against thermal and mechanical destruction.

**6.** Magnet arrangement according to any one of the preceding claims, **characterized in that** the sections $(A_1, ...A_n)$, and/or the ohmic resistors $(R_1, ...R_n)$ and the superconducting current paths $(P_1, P_2, P_3)$ are dimensioned such that, in case of an external magnetic field disturbance, the homogeneity of the magnetic field generated by the magnet arrangement in the working volume is maintained.

**7.** Magnet arrangement according to any one of the preceding claims, **characterized in that** the radially inner coil system is connected in series with the radially outer coil system of the actively shielded magnet, wherein said serial connection forms a first current path $(P_1)$ which is superconductingly short-circuited during operation, and that one compensation coil which is galvanically not connected to the two coil systems is arranged coaxially to the two coil systems and forms a further current path $(P_2, P_3)$ which is superconductingly short-circuited during operation.

**8.** Magnet arrangement according to any one of the preceding claims, **characterized in that** the radially inner coil system is connected in series with the radially outer coil system of the actively shielded magnet, wherein said serial connection forms a first current path $(P_1)$ which is superconductingly short-circuited during operation, and that a part of the inner and/or outer coil system of the actively shielded magnet can be short-circuited via a further superconducting switch $(S_2, S_3)$, thereby forming a further current path $(P_2, P_3)$ which is superconductingly short-circuited during operation.

**9.** Magnet arrangement according to any one of the claims 1 through 6, **characterized in that** at least part of the current paths $(P_1, P_2, P_3)$, which are superconductingly short-circuited during operation, is connected in series in a superconducting manner.

**10.** Magnet arrangement according to any one of the claims 1 through 6 or 9, **characterized in that** at least part of the current paths $(P_1, P_2, P_3)$, which are superconductingly short-circuited during operation, is connected to one another in a resistive manner and each of the current paths $(P_1, P_2, P_3)$ comprises at least one superconducting switch $(S_1, S_2, S_3)$.

**11.** Magnet arrangement according to any one of the claims 1 through 6, 9 or 10, **characterized in that** at least part of the current paths $(P_1, P_2, P_3)$, which are superconductingly short-circuited during operation, is galvanically not connected.

**12.** Magnet arrangement according to any one of the claims 7 through 11, **characterized in that** current limiters and/or ohmic resistors on the order of magnitude of $\mu\Omega$ to $m\Omega$ are inserted in the otherwise superconducting current paths at least at some locations where after charging the superconducting magnet arrangement no current flows in the initial state of operation.

**13.** Magnet arrangement according to any one of claims 7 through 12, **characterized in that** at least one superconducting switch $(S_1)$ comprises a heater which is electrically connected in series with the heater of the superconducting switch $(S_2, S_3)$ of at least one further current path $(P_2, P_3)$.

**14.** Magnet arrangement according to claim 13, **characterized in that** the heater of at least one superconducting switch $(S_1)$ can be heated by another switch heater $(S_2, S_3)$ via the serial connection, and can also be separately heated.

**15.** Magnet arrangement according to any one of the preceding claims, **characterized in that** the radially inner and the radially outer coil system of the actively shielded magnet have different polarities such that the current paths $(P_1, P_2, P_3)$ which are superconductingly short-circuited during operation are inductively decoupled from each other.

**16.** Magnet arrangement according to any one of the preceding claims, **characterized in that** one or more of the current paths $(P_1, P_2, P_3)$ with closed superconducting loop comprise coils with different winding radii and/or different current densities, wherein said coils are coaxial to the actively shielded magnet.

**17.** Magnet arrangement according to any one of the preceding claims, **characterized in that** the sections $(A_1, ... A_n)$ and the ohmic resistors $(R_1, ... R_n)$ are chosen such that the external magnetic field disturbance in the working volume is compensated for over the entire time range to a residual amount of less than 10%, preferably less than 5%, with particular preference less than 2%.

**18.** Method for calculation and optimization of a magnet arrangement according to any one of the claims 1 through 17, **characterized in that** the time behavior of the field strength of the magnetic field generated in the working volume is calculated after an external magnetic field disturbance in the form of a step function and influenced through variation of the design of the sections $(A_1, ... A_n)$ bridged through the ohmic resistors $(R_1, ... R_n)$, of the ohmic resistors $(R_1, ... R_n)$ and of the geometrical arrangement of the current paths $(P_1, P_2, P_3)$ which are superconductingly short-circuited during operation, such that the magnetic field disturbance $\Delta Bz$ in the working volume is reduced directly upon occurrence to a residual amount of $\beta_0 \cdot \Delta Bz$, wherein $|\beta_0| < |\beta\infty|$, and that subsequently, the residual amount $\beta(t) \cdot \Delta Bz$ of the magnetic field disturbance in the working volume monotonically approaches the value $\beta\infty \cdot \Delta Bz$ with a time constant of $\tau \geq 2$ sec, preferably $\tau \geq 5$ sec, in particular $\tau \cong 20$ sec.

**19.** Method according to claim 18, **characterized in that** also the time behavior of the second differentiation of the magnetic field strength in the working volume with respect to the coordinate of the field direction is used for optimization with the aim of influencing its variation with time after an external magnetic field disturbance in the form of a step function, in such a manner that the magnetic field disturbance $\Delta Bz$ in the working volume is reduced already directly upon its occurrence to a residual amount of $\beta_0 \cdot \Delta Bz$, wherein $|\beta_0| < |\beta\infty|$, and that subsequently, the residual amount $\beta(t) \cdot \Delta Bz$ of the magnetic field disturbance in the working volume monotonically approaches the value $\beta\infty \cdot \Delta Bz$ with a time constant of $\tau \geq 2$ sec, preferably $\tau \geq 5$ sec, in particular $\tau \cong 20$ sec.

**Revendications**

**1.** Configuration d'aimants supraconducteurs comprenant au moins deux trajets de courant $(P_1, P_2, P_3)$ court-circuités en position de service par des interrupteurs supraconducteurs $(S_1, S_2, S_3)$, trajets dans lesquels peuvent circuler différents courants, la configuration d'aimants comportant au moins un aimant supraconducteur écranné ou à écran actif avec des systèmes de bobine radialement externe et radialement interne, lesquels portent approximativement le même courant et comprennent approximativement des moments dipolaires opposés de même valeur, les trajets de courant $(P_1, P_2, P_3)$ étant dimensionnés de telle sorte qu'une perturbation du champ magnétique $\Delta Bz$ externe et échelonnée, dans la direction z de l'axe de symétrie de la configuration d'aimants dans un volume actif au centre de la configuration d'aimants, dans un comportement en longue durée, est atténuée jusqu'à une valeur résiduelle rémanente $\beta_\infty \cdot \Delta B_z$ avec $|\beta_\infty| < 0,2$,

    **caractérisé en ce que**

    les sections $(A_1, A_2, ..., A_n)$ des trajets de courant $(P_1, P_2, P_3)$ court-circuités par les interrupteurs supraconducteurs $(S_1, S_2, S_3)$ sont pontées par des résistances ohmiques $(R_1, R_2, ..., R_n)$, et **en ce que** ces sections $(A_1, A_2, ..., A_n)$ et les résistances ohmiques $(R_1, R_2, ..., R_n)$ sont sélectionnées de sorte que la perturbation du champ magnétique $\Delta B_z$ dans le volume actif est déjà réduite, immédiatement après son apparition, à une valeur résiduelle $\beta_0 \cdot \Delta B_z$, $|\beta_0| < |\beta_\infty|$, et **en ce qu'**ensuite la valeur résiduelle $\beta(t) \cdot \Delta B_z$ de la perturbation du champ magnétique dans le volume actif s'approche de façon monotone avec une constante de temps $\tau \geq 2$ sec, de préférence $\tau \geq 5$ sec, en particulier $\tau \cong 20$ sec, de la valeur $\beta_\infty \cdot \Delta B_z$, sachant que

$$\beta(t) = 1 + \frac{b \cdot \Delta I(t)}{\Delta B_z}$$

    avec

b : vecteur des champs magnétiques de chaque section (A$_1$, A$_2$, ...A$_n$) au centre de la configuration d'aimants pour respectivement un courant de 1 ampère,

$\Delta$I(t) : vecteur des modifications de courant induites par une perturbation échelonnée $\Delta$B$_z$ dans les sections (A$_1$, A$_2$,..., A$_n$),

$$\beta_\infty = \lim_{t\to\infty} \beta(t)$$

$$\beta_0 = \beta(t = 0)$$

2. Configuration d'aimants selon la revendication 1, **caractérisée en ce que** la configuration d'aimants fait partie d'un appareil de spectroscopie par résonance magnétique de haute résolution.

3. Configuration d'aimants selon la revendication 2, **caractérisée en ce que** l'appareil de résonance magnétique comprend un dispositif de verrouillage de champ du champ magnétique généré dans le volume actif, les trajets de courant supraconducteurs (P$_1$, P$_2$, P$_3$) étant découplés des bobines de verrouillage.

4. Configuration d'aimants selon la revendication 2 ou 3, **caractérisée en ce que** l'appareil de résonance magnétique comprend des bobines de balayage, les trajets de courant supraconducteurs (P$_1$, P$_2$, P$_3$) étant découplés des bobines de balayage.

5. Configuration d'aimants selon l'une quelconque des revendications précédentes, **caractérisée en ce que** les résistances ohmiques (R$_1$, R$_2$, ..., R$_n$), en cas de transition supraconductrice, occupent la fonction de résistances protectrices destinées à protéger la configuration d'aimants contre une détérioration thermique et mécanique.

6. Configuration d'aimants selon l'une quelconque des revendications précédentes, **caractérisée en ce que** les sections (A$_1$, ..., A$_n$) et/ou les résistances ohmiques (R$_1$, ..., R$_n$) et les trajets de courant supraconducteurs (P$_1$, P$_2$, P$_3$) sont dimensionnés de sorte qu'à l'apparition d'une perturbation externe du champ magnétique, l'homogénéité du champ magnétique généré dans le volume actif par la configuration d'aimants reste la même.

7. Configuration d'aimants selon l'une quelconque des revendications précédentes, **caractérisée en ce que** le système de bobine radialement interne est couplé en série au système de bobine radialement externe de l'aimant écranné ou à écran actif, ce couplage en série formant un premier trajet de courant (P$_1$) court-circuité de façon supraconductrice en position de service, et **en ce qu'**une bobine de compensation non couplée galvaniquement aux deux systèmes de bobine est disposée de manière coaxiale aux deux systèmes de bobine et forme un autre trajet de courant (P$_2$, P$_3$) court-circuité de façon supraconductrice en position de service.

8. Configuration d'aimants selon l'une quelconque des revendications précédentes, **caractérisée en ce que** le système de bobine radialement interne est couplé en série au système de bobine radialement externe de l'aimant écranné ou à écran actif, ce couplage en série formant un premier trajet de courant (P$_1$) court-circuité de façon supraconductrice en position de service, et **en ce qu'**une partie du système de bobine interne et/ou du système de bobine externe de l'aimant écranné ou à écran actif peut être court-circuitée par un autre interrupteur supraconducteur (S$_2$, S$_3$) et forme de ce fait un autre trajet de courant (P$_2$, P$_3$) court-circuité de façon supraconductrice en position de service.

9. Configuration d'aimants selon l'une quelconque des revendications 1 à 6, **caractérisée en ce qu'**au moins une partie des trajets de courant (P$_1$, P$_2$, P$_3$) court-circuités de façon supraconductrice en position de service est couplée en série de façon supraconductrice les uns aux autres.

10. Configuration d'aimants selon l'une quelconque des revendications 1 à 6 ou 9, **caractérisée en ce qu'**au moins une partie des trajets de courant (P$_1$, P$_2$, P$_3$) court-circuités de façon supraconductrice en position de service est couplée de façon résistive les uns aux autres, et **en ce que** chacun des trajets de courant (P$_1$, P$_2$, P$_3$) comprend au moins un interrupteur supraconducteur (S$_1$, S$_2$, S$_3$).

11. Configuration d'aimants selon l'une quelconque des revendications 1 à 6, 9 ou 10, **caractérisée en ce qu'**au moins une partie des trajets de courant ($P_1$, $P_2$, $P_3$) raccordés de façon supraconductrice en position de service n'est pas couplée galvaniquement.

12. Configuration d'aimants selon l'une quelconque des revendications 7 à 11, **caractérisée en ce qu'**au moins en quelques points, au niveau desquels aucun courant ne circule après le chargement de la configuration d'aimants supraconducteurs en position initiale, des limiteurs de courant, et/ou des résistances ohmiques de l'ordre de grandeur de $\mu\Omega$ à $m\Omega$ sont insérés dans les trajets de courant normalement supraconducteurs.

13. Configuration d'aimants selon l'une quelconque des revendications 7 à 12, **caractérisée en ce qu'**au moins un interrupteur supraconducteur ($S_1$) comprend un dispositif de chauffage, qui est couplé électriquement en série au dispositif de chauffage de l'interrupteur supraconducteur ($S_2$, $S_3$) d'au moins un autre trajet de courant ($P_2$, $P_3$).

14. Configuration d'aimants selon la revendication 13, **caractérisée en ce que** le dispositif de chauffage d'au moins un interrupteur supraconducteur ($S_1$) peut être chauffé aussi bien par le couplage en série à un autre dispositif de chauffage d'interrupteur ($S_2$, $S_3$) que de façon séparée.

15. Configuration d'aimants selon l'une quelconque des revendications précédentes, **caractérisée en ce que** les systèmes de bobine radialement interne et radialement externe de l'aimant écranné ou à écran actif comprennent des polarités différentes, de sorte que les trajets de courant ($P_1$, $P_2$, $P_3$) court-circuités de façon supraconductrice en position de mesure sont découplés de façon inductive les uns des autres.

16. Configuration d'aimants selon l'une quelconque des revendications précédentes, **caractérisée en ce qu'**un ou plusieurs des trajets de courant ($P_1$, $P_2$, $P_3$) fermés de façon supraconductrice comporte des bobines présentant différents rayons d'enroulement et/ou des différentes densités de courant, ces bobines étant coaxiales à l'aimant écranné ou à écran actif.

17. Configuration d'aimants selon l'une quelconque des revendications précédentes, **caractérisée en ce que** les sections ($A_1$, ..., $A_n$) et les résistances ohmiques ($R_1$, ..., $R_n$) sont sélectionnées de sorte que sur l'ensemble de la plage temporelle, une compensation de la perturbation externe du champ magnétique dans le volume actif à une valeur résiduelle de moins de 10%, de préférence de moins de 5%, de manière particulièrement préférée de moins de 2%, soit provoquée.

18. Procédé de calcul et d'optimisation d'une configuration d'aimants selon l'une quelconque des revendications 1 à 17, **caractérisée en ce que** le tracé temporel de l'intensité de champ du champ magnétique généré dans le volume actif est calculé selon une perturbation externe du champ magnétique s'installant brusquement et est influencé par la variation de la dimension des sections ($A_1$, ..., $A_n$) pontées par les résistances ohmiques ($R_1$, ..., $R_n$), par les résistances ohmiques ($R_1$, ..., $R_n$) ainsi que par la disposition géométrique des trajets de courant ($P_1$, $P_2$, $P_3$) court-circuités de façon supraconductrice en position de service, de telle sorte que la perturbation du champ magnétique $\Delta B_z$ dans le volume actif est déjà réduite, immédiatement après son apparition, à une valeur résiduelle $\beta_0 \cdot \Delta B_z$, $|\beta_0| < |\beta_\infty|$, et **en ce qu'**ensuite la valeur résiduelle $\beta(t) \cdot \Delta B_z$ de la perturbation du champ magnétique dans le volume actif s'approche de façon monotone avec une constante de temps $\tau \geq 2$ sec, de préférence $\tau \geq 5$ sec, en particulier $\tau \cong 20$ sec, de la valeur $\beta_\infty \cdot \Delta B_z$.

19. Procédé selon la revendication 18, **caractérisé en ce qu'**on a également recours au tracé temporel de la seconde dérivation de l'intensité du champ magnétique dans le volume actif en fonction des coordonnées de la direction du champ en vue d'une optimisation, avec l'objectif d'influencer sa modification temporelle après une perturbation externe du champ magnétique s'installant brusquement, de telle sorte que la perturbation du champ magnétique $\Delta B_z$ dans le volume actif est déjà réduite, immédiatement après son apparition, à une valeur résiduelle $\beta_0 \cdot \Delta B_z$, $|\beta_0| < |\beta_\infty|$, et **en ce qu'**ensuite la valeur résiduelle $\beta(t) \cdot \Delta B_z$ de la perturbation du champ magnétique dans le volume actif s'approche de façon monotone avec une constante de temps $\tau \geq 2$ sec, de préférence $\tau \geq 5$ sec, en particulier $\tau \cong 20$ sec, de la valeur $\beta_\infty \cdot \Delta B_z$.

Fig. 1

Fig. 2

Fig. 3

Fig. 4

Fig. 5